Europäisches Patentamt

European Patent Office

Office européen des brevets

(11) Numéro de publication : **0 013 342**
**B1**

# FASCICULE DE BREVET EUROPÉEN

(45) Date de publication du fascicule du brevet :
24.02.82

(51) Int. Cl.³ : **H 01 L 29/80**, H 01 L 21/18

(21) Numéro de dépôt : **79104878.8**

(22) Date de dépôt : **04.12.79**

(54) **Procédé de fabrication de transistors à effet de champ auto-alignés du type métal-semi-conducteur.**

(30) Priorité : **29.12.78 US 974592**

(43) Date de publication de la demande :
**23.07.80 (Bulletin 80/15)**

(45) Mention de la délivrance du brevet :
**24.02.82 Bulletin 82/08**

(84) Etats contractants désignés :
**DE FR GB**

(56) Documents cités :
**GB - A - 1 499 090**
**US - A - 3 855 690**
**IEEE JOURNAL OF SOLID-STATE CIRCUITS**
**Vol. SC-12, No 4, août 1977 New York**
**H. HOSACK et al. « Submicron patterning of surfaces » pages 363 à 367.**

(73) Titulaire : **International Business Machines Corporation**

**Armonk, N.Y. 10504 (US)**

(72) Inventeur : **Triebwasser, Sol**
**56 Lakeview Drive**
**West Peekskill, New York 10566 (US)**

(74) Mandataire : **Colas, Alain**
**COMPAGNIE IBM FRANCE Département de Propriété Industrielle**
**F-06610 - La Gaude (FR)**

Imprimerie Jouve, 18, rue St-Denis, 75001 Paris, France

Procédé de fabrication de transistors à effet de champ auto-alignés du type métal-semi-conducteur

### Description

#### Domaine technique

La présente invention concerne un procédé de fabrication de transistors à effet de champ (FET) et, plus particulièrement, un procédé de fabrication de transistors à effet de champ du type métal-semi-conducteur (MESFET).

#### Etat de la technique antérieure

Dans les premiers dispositifs MESFET, une distance relativement importante séparait, d'une part, la porte du drain et, d'autre part, la porte de la source. En général, cette distance correspondait à la largeur de la porte, si bien que la distance minimum séparant la source du drain était égale à trois fois environ la largeur minimum de la porte. Etant donné que seule, la région située au-dessous de la porte est commandée électriquement, deux tiers du canal présentaient une résistance parasite. Diverses solutions ont été proposées dans l'art antérieur pour résoudre ce problème. Par exemple, celle décrite dans le brevet des E.U.A. No. 3 609 477 consiste à utiliser des matériaux fortement conducteurs dans la région parasite de manière à réduire ladite résistance. On a également cherché à résoudre ce problème, selon les brevets des E.U.A. No. 3 855 690 et 3 943 622, en faisant croître des régions de source et de drain à facettes, généralement appelées des mesas. Ces mesas se trouvent à une certaine distance les uns des autres, les facettes comportant des bords en surplomb. Les sources et les drains à facettes sont employés comme masques pour le dépôt d'une porte à barrière de Schottky. Les régions en surplomb constituent un écran pour la partie de la surface qui se trouve à proximité immédiate de la source et du drain, empêchant ainsi la formation de courts-circuits notamment entre la source et la porte. La solution préconisée dans ces deux derniers brevets ne résoud qu'en partie le problème posé par la résistance parasite. En effet, elle exige tout d'abord que le dispositif possède une géométrie complexe et que les régions de source et de drain reliées épitaxialement au substrat. De plus, elle nécessite la présence de facettes sur les parties en surplomb, ce qui limite les orientations possibles du substrat sur lequel on peut faire croître épitaxialement des mesas à facettes, une orientation (001) du cristal semi-conducteur constituant l'orientation préférée. Enfin, la solution préconisée ne permet pas de déposer un matériau isolant entre la source et la porte ou entre le drain et la porte, ce qui a pour effet de réduire les possibilités d'obtention d'une faible séparation, sans fuite ou sans court-circuit, entre la porte d'une part et la source et le drain d'autre part. Une autre technique, décrite dans le brevet des E.U.A. No. 3 906 541, consiste à employer des mesas que l'on fait croître épitaxialement sur un substrat et qui, comme précédemment, servent de masque aux fins des étapes ultérieures. Cette dernière technique présente les mêmes inconvénients que ceux précédemment décrits.

Un autre procédé, décrit dans le brevet des E.U.A. No. 3 909 925, consiste à former des portes en polysilicium et en aluminium séparées les unes des autres. Dans ce procédé, une couche de dioxyde de silicium entoure complètement les portes en polysilicium, ce qui permet d'obtenir des dispositifs dans lesquels les portes en polysilicium et les portes en aluminium sont isolées du substrat. Ce dernier procédé n'est pas applicable à la fabrication de dispositifs MESFET.

#### Exposé de l'invention

L'un des objets de la présente invention est donc de fournir des dispositifs MESFET auto-alignés présentant une résistance série réduite.

Un autre objet de l'invention est de réaliser une isolation entre la source, le drain et la porte d'un dispositif MESFET.

Un autre objet de l'invention est de réaliser, dans un dispositif MESFET, des régions de source et de drain en silicium qui sont fixées au substrat semi-conducteur.

Un autre objet de l'invention est de fournir un dispositif MESFET présentant une surface minimum.

La présente invention permet notamment d'atteindre les objectifs ci-dessus en utilisant une technique de fabrication de transistors auto-alignés, à effet de champ et à barrière de Schottky (MESFET) comme décrit ci-après. Un dispositif MESFET est réalisé en déposant sur un corps semi-conducteur une couche épitaxiale de polarité opposée, cette couche étant recouverte d'une couche de $SiO_2$, elle-même recouverte d'une couche de $Si_3N_4$. Une résine photo-sensible est ensuite déposée sur la couche de $Si_3N_4$, exposée et développée pour définir une configuration d'ouvertures et pour exposer des régions déterminées de la couche de $Si_3N_4$.

On retire ensuite par décapage les parties exposées de la couche de $Si_3N_4$ et l'on poursuit le décapage dans la couche de $SiO_2$ sous-jacente de manière à exposer certaines régions de la couche épitaxiale. Du silicium dopé est ensuite déposé sur les régions exposées du silicium épitaxial, puis l'on retire les parties non exposées de la résine photo-sensible de manière à conserver des mesas en Si dopé constituant des régions de source et de drain, les parties du substrat situées entre ces régions étant réservées aux fins du dépôt ultérieur de régions de porte.

Une seconde couche de résine photo-sensible est appliquée sur la couche de $Si_3N_4$ et sur les mesas en Si. Cette résine est ensuite exposée et développée à l'exception de la région réservée à la réalisation d'une porte métallique. Les régions de la couche de $Si_3N_4$ exposées lors du développement sont retirées par décapage, puis la résine photo-sensible est retirée des régions de porte. Les mesas en Si sont oxydées. Enfin, le $Si_3N_4$ est retiré par décapage, de même que la couche sous-jacente de $SiO_2$. Une porte métallique est définie, au moyen d'une configuration appropriée, sur la couche épitaxiale exposée, en utilisant des techniques classiques faisant appel à l'emploi de résines photo-sensibles. Une couche métallique convenable peut ultérieurement être déposée par évaporation pour réaliser des contacts de source, de drain et de porte de Schottky, ainsi que le réseau d'interconnexion.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des Figures

La Figure 1 représente, en coupe, un transistor à effet de champ et à barrière de Schottky de l'art antérieur.

La Figure 2 représente, en coupe, un transistor à effet de champ et à barrière de Schottky réalisé conformément à la présente invention.

Les Figures 3A à 3G représentent, en coupe, différentes étapes de fabrication d'un transistor à effet de champ et à barrière de Schottky du type représenté sur la Figure 2.

Description de l'invention

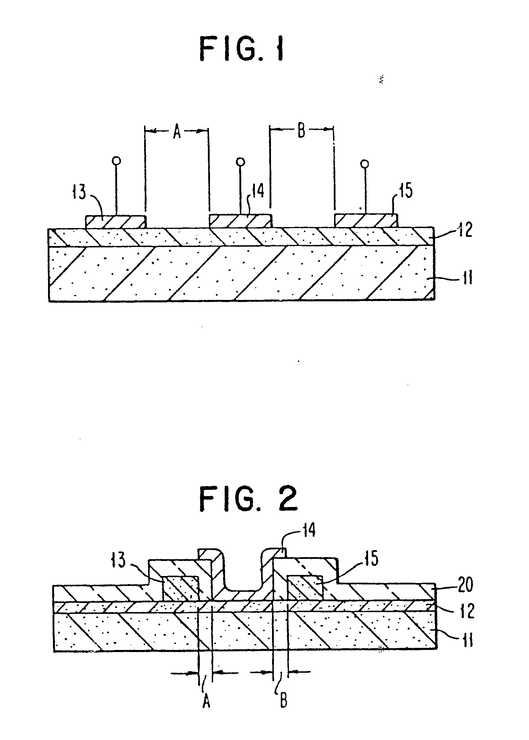

On a représenté sur la Figure 1 un dispositif MESFET de l'art antérieur. Un corps semi-conducteur 11 est recouvert d'une couche épitaxiale 12 d'une polarité opposée à celle du corps 11. Une source 13, une porte 14 et un drain 15 sont déposés à la surface de la couche épitaxiale 12. La source 13, la porte 14 et le drain 15 sont définis au moyen de techniques lithographiques standard, ce qui a pour effet de laisser un espace A entre la porte 14 et la source 13, et un espace B entre la porte 14 et le drain 15, chacun desdits espaces correspondant environ à la largeur de la porte 14. Les espaces A et B sont, pour une grande part, à l'origine de la résistance parasite du dispositif, et définissent les limites inférieures des dimensions du MESFET résultant.

La Figure 2 représente un dispositif MESFET réalisé conformément au procédé de la présente invention. Lors de la mise en œuvre de ce procédé, on peut ramener les dimensions de l'espace A entre la source 13 et la porte 14, et de l'espace B entre la porte 14 et le drain 15 à l'épaisseur d'une couche d'oxyde 20.

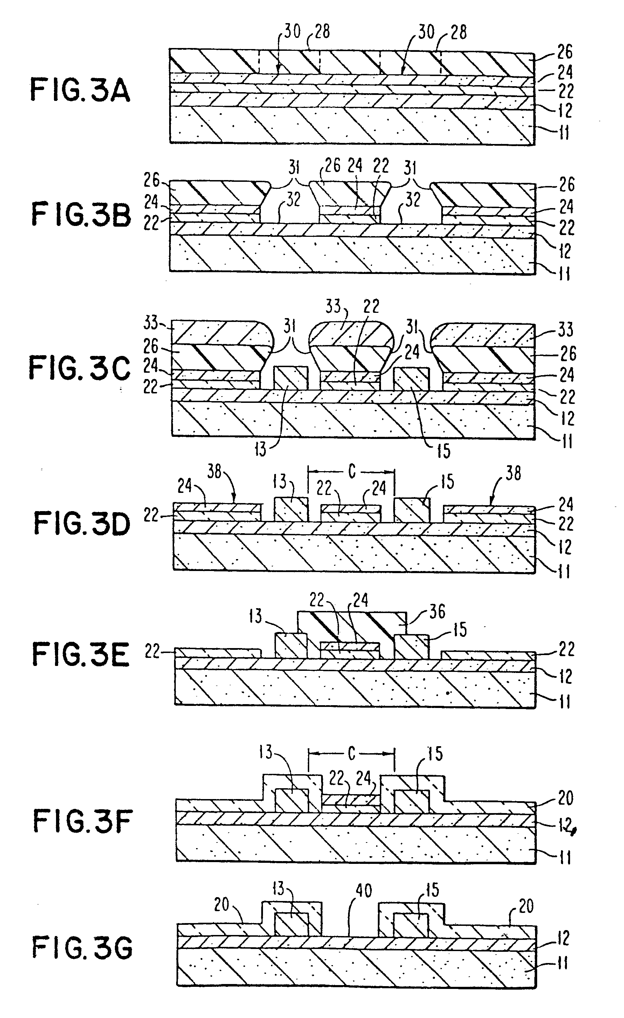

Les Figures 3A à 3G illustrent différentes étapes de la réalisation d'un transistor MESFET conformément au procédé de la présente invention. Comme le montre la Figure 3A, un dispositif MESFET est réalisé sur un corps semi-conducteur 11 en faisant d'abord croître sur celui-ci une couche épitaxiale 12 de type de conductivité opposé. Si, par exemple, la couche 12 est de type n, son épaisseur devrait être comprise entre 1 000 Å et 10 000 Å et elle devrait être dopée au moyen d'As ou de P jusqu'à obtention d'un niveau de $10^{15}$ à $10^{16}$ donneurs par $cm^3$, les valeurs exactes étant fonction du mode de fonctionnement désiré, c'est-à-dire du mode d'enrichissement ou du mode d'appauvrissement. Une couche de dioxyde de silicium 22 d'une épaisseur comprise entre 100 Å et 1 000 Å environ, est ensuite déposée sur la couche épitaxiale 12. Cette épaisseur minimum d'environ 100 Å permet d'éviter que la partie sous-jacente de la structure ne soit endommagée par suite de l'existence de contraintes lors des étapes ultérieures de dépôt. De préférence, l'épaisseur de la couche 22 devrait être d'environ 150 Å. Cette couche est ensuite recouverte d'une couche 24 de $Si_3N_4$, dont l'épaisseur peut varier entre 200 Å et 1 000 Å environ et doit être de préférence d'environ 500 Å. Si son épaisseur est inférieure à environ 200 Å, la couche 24 ne protège pas suffisamment la structure sous-jacente pour éviter une oxydation supplémentaire. Une première couche de résine photo-sensible 26, d'une épaisseur comprise entre 5 000 Å et 10 000 Å environ, est ensuite déposée sur la couche 24.

La couche 26 est ensuite exposée de façon sélective et développée de manière à former une configuration déterminée d'ouvertures 28, ce qui a pour effet d'exposer des régions 30 de la couche 24 de $Si_3N_4$. La technique employée aux fins de cette exposition sélective et de ce développement doivent permettre d'obtenir un profil 31, présentant un décapage latéral, comme le montre la Figure 3B. Une technique permettant d'obtenir un tel profil est décrite dans l'article de B.J. Carvanello, M. Hatzakis et J.M. Shaw, intitulé « Process for Obtaining Undercutting of a Photoresist to Facilitate Lift Off », paru dans la publication intitulée « IBM Technical Disclosure Bulletin » Vol. 19, No. 10, page 4 048, Mars 1977. Les régions exposées 30 de la couche 24 sont décapées au moyen d'une technique de décapage chimique faisant appel à l'emploi d'une solution de $H_3PO_4$ portée à une température de 180 °C, ou au moyen d'ions réactifs engendrés à partir d'un mélange de 70 % de $CF_4$ et de 30 % d'$H_2$. Cette dernière technique de décapage sera employée de préférence. Le décapage se poursuit jusqu'à ce que le nitrure de silicium ainsi que la couche 22 en $SiO_2$ aient été retirés des régions 30. Cela a pour effet d'exposer les régions 32 de la couche épitaxiale 12, comme le montre la Figure 3B.

On dépose ensuite par évaporation du Si dopé sur la couche 26 de résine photo-sensible et sur les régions exposées 32 de la couche épitaxiale. Ce Si dopé recouvre la résine photo-sensible d'une couche de polysilicium 33 et forme une source 13 et un drain 15 en polysilicium, comme le montre la Figure 3C. Si la couche épitaxiale est du silicium du type n, il convient d'employer du silicium dopé avec du phosphore jusqu'à obtention d'un niveau de $10^{20}$ donneurs par $cm^3$. L'évaporation peut être obtenue en chauffant le silicium au moyen d'un faisceau électronique. Les couches 26 et 33 peuvent ensuite être retirées au moyen d'un solvant tel que de l'acétone. On obtient alors des mesas 13 et 15 servant respectivement de source et de drain, la région qui les sépare, C, étant réservée aux fins du dépôt ultérieur d'une porte, comme le montre la Figure 3D. Une seconde couche 36 de résine photo-sensible, présentant une épaisseur comprise entre 5 000 Å et 10 000 Å environ, est appliquée sur la couche 24 de $Si_3N_4$ et sur les mesas dopés 13 et 15.

La couche 36 est exposée de façon sélective et développée de manière à exposer certaines parties de la couche 24 et des mesas 13 et 15, tout en recouvrant la partie du film 24 qui recouvre la région réservée aux portes. La couche 26, après développement, est représentée sur la Figure 3E. Les parties exposées 38 du film 24 sont ensuite retirées par décapage. A titre d'exemple, si le film présente une épaisseur d'environ 500 Å, son retrait peut être effectué par décapage chimique, effectué de préférence au moyen de $H_3PO_4$ à 180 °C pendant cinq minutes environ. Une autre étape de décapage permet d'éliminer, si besoin est, la couche 22 située dans les régions 38. La couche 36 restante est ensuite retirée au moyen d'un solvant tel que de l'acétone et le dispositif est prêt à subir une oxydation. Les mesas 13 et 15 sont oxydées thermiquement, de préférence dans de la vapeur à 1 000 °C environ pendant plusieurs minutes, de manière à créer une couche d'oxyde d'une épaisseur d'environ 1 000 Å. Pendant cet intervalle de temps, les couches d'oxyde qui se trouvent dans les régions 38 continuent à épaissir. La structure résultante est représentée sur la Figure 3F. La partie restante du film 24 de $Si_3N_4$ qui recouvre la région C réservée aux portes est retirée par décapage chimique ; celui-ci sera de préférence effectué, comme précédemment, au moyen d'un décapant tel que du $H_3PO_4$ à 180 °C pendant cinq minutes environ. La couche 22 de $SiO_2$ peut être retirée par décapage au moyen d'une solution d'acide fluorhydrique tamponnée avec du $NH_4F$. On expose ainsi une partie 40 de couche épitaxiale 12 sur laquelle un métal peut être déposé de manière à constituer une porte.

Si ce métal est choisi parmi les métaux susceptibles de former une barrière de Schottky avec le Si, par exemple le Pt, le Ti ou le W, on obtient un dispositif MESFET à barrière de Schottky. Des siliciures métalliques, tels que du $PdSi_2$ ou du PtSi, peuvent aussi être employés.

Il est également possible de former une région de porte à jonction en introduisant un dopant du type p dans la partie exposée 40 de la couche 12. Cette introduction peut être effectuée soit par diffusion thermique, soit par implantation ionique, cette dernière technique étant préférée car elle limite la diffusion latérale du dopant. L'électrode de porte déposée doit former un contact ohmique avec la région de porte. L'aluminium est un métal adéquat qui peut être employé pour constituer la porte.

Les portes peuvent être définies au moyen de techniques lithographiques classiques dans lesquelles la résine photo-sensible est d'abord appliquée, après quoi les régions de celle-ci qui se trouvent au-dessus de la région de porte sont exposées et développées. De nouveau, cela a pour effet d'exposer la partie 40 du substrat sur laquelle le métal est déposé.

On peut ultérieurement procéder au dépôt par évaporation d'une couche d'aluminium ou d'un autre métal convenable, couche dans laquelle des contacts de source, de drain et de porte ainsi que des interconnexions peuvent ensuite être définis en fonction d'une configuration prédéterminée.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Procédé de fabrication de dispositifs semiconducteurs à effet de champ, du type MESFET, auto-alignés, caractérisé en ce qu'il comprend les étapes suivantes :

réaliser un corps semi-conducteur (11) sur lequel est déposée une couche épitaxiale (12) de polarité opposée à celle dudit corps ;

faire croître sur ladite couche épitaxiale (12) une couche de $SiO_2$ (22) d'une épaisseur comprise entre environ 100 Å et 1 000 Å ;

déposer sur ladite couche de $SiO_2$ une couche de $Si_3N_4$ (24) d'une épaisseur comprise entre environ 200 Å et 1 000 Å ;

appliquer, sur ladite couche de $Si_3N_4$, une première couche de résine photo-sensible (26) d'une épaisseur comprise entre environ 5 000 Å et 10 000 Å ;

exposer, de façon sélective, ladite première couche de résine photo-sensible (26) et la développer de façon à obtenir un décapage latéral et à définir, selon une configuration prédéterminée, des ouvertures (31) exposant des régions (30) de source et de drain dans ladite couche de $Si_3N_4$ ;

procéder à un décapage de façon à enlever la couche de $Si_3N_4$ dans lesdites régions (30) de source et de drain exposées ;

poursuivre ledit décapage de manière à enlever ladite couche de $SiO_2$ (22) située au-dessous desdites régions exposées de la couche de $Si_3N_4$, exposant ainsi certaines régions (32) de ladite couche épitaxiale (12) ;

déposer par évaporation du Si dopé sur les régions (32) exposées de ladite couche épitaxiale ;

éliminer par décapage la partie non exposée de ladite première couche de résine photo-sensible (26), laissant ainsi des mesas dopées servant de régions de source (13) et de drain (15) et séparées par une région qui est réservée au dépôt ultérieur de portes ;

appliquer une seconde couche de résine photo-sensible (36) sur ladite couche de $Si_3N_4$ et sur lesdites mesas dopées, l'épaisseur de ladite seconde couche étant comprise entre environ 5 000 Å et 10 000 Å ;

exposer de façon sélective ladite seconde couche de résine photo-sensible (36) et la développer de manière à exposer certaines parties de ladite couche de $Si_3N_4$ et desdites mesas, ladite seconde couche de résine recouvrant la partie dudit film de $Si_3N_4$ (24) qui se trouve au-dessus de ladite région réservée au dépôt ultérieur de portes ;

retirer par décapage lesdites parties exposées de la couche de $Si_3N_4$ ;

éliminer la partie non exposée de ladite seconde couche de résine photo-sensible (36) ;

oxyder lesdites mesas (13, 15) de manière à les recouvrir d'une couche d'oxyde (20) d'une épaisseur d'environ 1 000 Å ;

décaper ledit film de $Si_3N_4$ (24) situé au-dessus de ladite région réservée au dépôt de portes ;

décaper ledit film de $SiO_2$ (22) dans ladite région réservée au dépôt ultérieur de portes, exposant ainsi la couche épitaxiale recouvrant le substrat ; et

former des portes en déposant, selon une configuration prédéterminée, un métal (14) dans la partie exposée de ladite couche épitaxiale.

2. Procédé selon la revendication 1, caractérisé en ce que l'épaisseur de ladite couche de $SiO_2$ déposée sur la couche épitaxiale est d'environ 250 Å et que celle de ladite couche de $Si_3N_4$ est d'environ 500 Å.

3. Procédé selon l'une quelconque des revendications 1 ou 2, caractérisé en ce que le décapage de ladite couche de $Si_3N_4$ (24) et de ladite couche de $SiO_2$ (22) pour définir les régions de source (13) et de drain (15), est effectué au moyen d'ions réactifs, les ions étant engendrés à partir d'un mélange composé de 70 % environ de $CF_4$ et de 30 % environ de $H_2$.

4. Procédé selon l'une quelconque des revendications 1 à 3, caractérisé en ce que ledit métal appartient au groupe constitué par le Pt, le Ti ou W, formant ainsi une barrière de Schottky.

5. Procédé selon l'une quelconque des revendications 1 à 3, caractérisé en ce que, avant ledit dépôt de métal dans la partie exposée de ladite couche épitaxiale, des impuretés sont introduites dans la partie exposée de la structure pour former une jonction.

6. Procédé selon la revendication 5, caractérisé en ce que les impuretés sont introduites par implantation ionique.

7. Procédé selon l'une des revendications 5 ou 6, caractérisé en ce que l'électrode de porte est constituée par de l'aluminium.

**Claims**

1. A method for producing field effect, self-aligned semiconductor devices of the MESFET type, characterized in that it comprises the steps of :

forming a semiconductor body (11) coated with an epitaxial layer (12) having a polarity opposite to that of said body ;

growing on said epitaxial layer (12) an $SiO_2$ layer (22) of a thickness between about 100 Å and 1 000 Å ;

depositing on said $SiO_2$ layer an $Si_3N_4$ layer (24) of a thickness between about 200 Å and 1 000 Å ;

applying to said $Si_3N_4$ layer a first photo-resist layer (26) of a thickness between about 5 000 and 10 000 Å ;

selectively exposing said first photo-resist layer (26) and developing it so as to obtain a lateral etching and to define, according to a predetermined pattern, the windows (31) exposing the source and drain regions (30) in said $Si_3N_4$ layer ;

proceeding to an etching process so as to eliminate the $Si_3N_4$ layer in said exposed source and drain regions (30) ;

continuing said etching process so as to eliminate the $SiO_2$ layer (22) located over said exposed regions of the $Si_3N_4$ layer, thus exposing certain regions (32) of said epitaxial layer (12) ;

vapour-depositing doped silicon onto the exposed regions (32) of said epitaxial layer ;

etching the non-exposed part of said first photo-resist layer (26) so as to eliminate it, thus leaving doped mesas which serve as source (13) and drain (15) regions and which are separated by a region reserved for subsequent deposition of the gates ;

applying a second photo-resist layer (36) on said $Si_3N_4$ layer and on said doped mesas, the thickness of said second layer ranging from about 5 000 Å to 10 000 Å;

selectively exposing said second photo-resist layer (36) and developing the same so as to expose certain portions of said $Si_3N_4$ layer and said mesas, whereby the second photo-resist layer covers the part of said $Si_3N_4$ film (24) located over said region which is reserved for subsequent deposition of the gates ;

eliminating by an etching process said exposed parts of the $Si_3N_4$ layer ;

eliminating the non-exposed part of said second photo-resist layer (36) ;

oxidizing said mesas (13, 15) so as to coat them with an oxide layer (20) of a thickness of about 1 000 Å ;

etching said $Si_3N_4$ film (24) located over said region reserved for deposition of the gates ;

etching said $SiO_2$ film (22) in said region reserved for subsequent deposition of the gates, thus exposing the epitaxial layer covering the substrate ;

and forming the gates by depositing, according to a predetermined pattern, a metal (14) onto the exposed part of said epitaxial layer.

2. A method according to claim 1, characterized in that the thickness of said $SiO_2$ layer deposited on the epitaxial layer is about 250 Å and that of said $Si_3N_4$ layer is about 500 Å.

3. A method according to claim 1 or 2, characterized in that etching said Si₃N₄ layer (24) and said SiO₂ layer (22) to define the source (13) and drain (15) regions is performed by means of reactive ions, the latter being generated from a mixture composed of about 70 % of $CF_4$ and of 30 % of $H_2$.

4. A method according to any one of claims 1 to 3, characterized in that said metal is of the group including Pt, Ti or W, thus forming a Schottky barrier.

5. A method according to any one of claims 1 to 3, characterized in that, before depositing said metal onto the exposed parts of said epitaxial layer, impurities are introduced into the exposed part of the structure to produce a junction.

6. A method according to claim 5, characterized in that the impurities are introduced by ion implantation.

7. A method according to claim 5 or 6, characterized in that the gate electrode consists of aluminium.


## Ansprüche

1. Verfahren zum Herstellen von selbstausgerichteten Feldeffekt-Halbleitervorrichtungen vom MESFET Typ, dadurch gekennzeichnet, daß es folgende Verfahrensschritte einschließt :

Herstellen eines Halbleiterkörpers (11), der mit einer Epitaxieschicht (12) eines zu dem des Körpers entgegengesetzten Leitfähigkeitstyps beschichtet ist ;

Aufwachsen einer SiO₂-Schicht (22) mit einer Dicke von ungefähr 100 Å bis 1 000 Å auf diese Epitaxieschicht (12) ;

Abscheiden einer Si₃N₄-Schicht (24) mit einer Dicke von ungefähr 200 Å bis 1 000 Å auf diese SiO₂-Schicht ;

Auftragen einer ersten Photolackschicht (26) mit einer Dicke von ungefähr 5 000 Å bis 10 000 Å auf diese Si₃N₄-Schicht ;

Selektives Belichten der ersten Photolackschicht (26) und Entwickeln derselben um ein laterales Ätzen zu erhalten und um nach einem vorbestimmten Muster die Fenster (31) zu definieren, die die Source- und Drainbereiche (30) in der Si₃N₄-Schicht freilegen ;

Ätzen, um die Si₃N₄-Schicht in den freigelegten Source- und Drainbereichen (30) abzuheben ;

Weiterführung des Ätzvorganges, um die über den freigelegten Bereichen der Si₃N₄-Schicht liegende SiO₂-Schicht (22) abzugeben, und so gewisse Bereiche (32) der Epitaxieschicht (12) freizulegen ;

Niederschlag durch Verdampfen von dotiertem Silicium auf den freigelegten Bereichen (32) der Epitaxieschicht ;

Wegätzen des nicht freigelegten Teiles der ersten Photolackschicht (26), so daß dotierte Mesas zurückbleiben, die als Source- (13) und Drain- (15) Bereiche dienen und durch einen Bereich getrennt sind, der für das spätere Aufbringen der Gates bestimmt ist ;

Auftragen einer zweiten Photolackschicht (36) auf die Si₃N₄-Schicht und auf die dotierte Mesas, wobei die Dicke der zweiten Schicht zwischen 5 000 Å und 10 000 Å liegt ;

Selektives Belichten der zweiten Photolackschicht (36) und deren Entwicklung, um gewisse Teile dieser Si₃N₄-Schicht und der Mesas freizulegen, wobei die zweite Photolackschicht über den Teil des Si₃N₄-Filmes (24) bedeckt, der sich über dem für das spätere Aufbringen der Gates bestimmten Bereich befindet ;

Wegätzen der freiliegenden Teile der Si₃N₄-Schicht ;

Abnehmen des nicht freiliegenden Teils der zweiten Photolackschicht (36) ;

Oxydieren der Mesas (13, 15), um sie mit einer ungefähr 1 000 Å dicken Oxydschicht (20) zu beschichten ;

Ätzen des Si₃N₄-Filmes (24), der über dem für das spätere Aufbringen der Gates bestimmten Bereich liegt ;

Ätzen des SiO₂-Filmes (22) in dem für das spätere Aufbringen der Gates bestimmten Bereich, so daß die das Substrat bedeckende Epitaxieschicht freigelegt wird ; und

Herstellen der Gates durch Aufbringen nach einem vorbestimmten Muster eines Metalls (14) in dem freiliegenden Teil der Epitaxieschicht.

2. Verfahren nach Anspruch 1, dadurch gekennzeichnet, daß die Dicke der auf der Epitaxieschicht niedergeschlagenen SiO₂-Schicht etwa 250 Å und die der Si₃N₄-Schicht etwa 500 Å beträgt.

3. Verfahren nach Anspruch 1 oder 2, dadurch gekennzeichnet, daß das Ätzen der Si₃N₄-Schicht (24) und der SiO₂-Schicht (22) zum Definieren der Source- (13) und Drain- (15) Bereiche mit Hilfe von reaktiven Ionen vorgenommen wird, wobei die Ionen aus einer Mischung gewonnen werden, die aus ungefähr 70 % $CF_4$ und ungefähr 30 % $H_2$ besteht.

4. Verfahren nach einem der Ansprüche 1 bis 3, dadurch gekennzeichnet, daß das Metall der von Pt, Ti oder W gebildeten Gruppe angehört und so eine Schottky-Sperrschicht bildet.

5. Verfahren nach einem der Ansprüche 1 bis 3, dadurch gekennzeichnet, daß vor dem Metallbeschichten des freiliegenden Teils der Epitaxieschicht Fremdstoffe in den freiliegenden Teil der Struktur eingebracht werden, um einen Übergang zu bilden.

6. Verfahren nach Anspruch 5, dadurch gekennzeichnet, daß die Fremdstoffe durch Ionenimplantation eingebracht werden.

7. Verfahren nach Anspruch 5 oder 6, dadurch gekennzeichnet, daß die Gateelektrode aus Aluminium besteht.

# FIG. 1

A ⟶  ⟵ B ⟶

13  14  15

12

11

# FIG. 2

13  14  15

20
12
11

A  B

FIG.3A

FIG.3B

FIG.3C

FIG.3D

FIG.3E

FIG.3F

FIG.3G